# EUROPEAN PATENT APPLICATION

(11) **EP 1 081 812 A1**
(43) Date of publication of application: **07.03.2001**
(21) Application number: 99830544.5
(22) Date of filing: 02.09.1999
(51) Int. Cl.: H01S 3/16, H01S 5/32

(54) **Semiconductor device for electro-optic applications, method for manufacturing said device and corresponding semiconductor laser device**

(71) Applicant: STMicroelectronics S.r.l., 20041 Agrate Brianza (Milano) (IT); CNR-IMETEM, 95121 Catania (IT)
(72) Inventor: Coffa, Salvatore, 95030 Tremestieri Etneo (IT); Libertino, Sebania, 95127 Catania (IT); Saggio, Mario, 95125 Catania (IT); Frisina, Ferruccio, 95121 Catania (IT)
(74) Representative: Botti, Mario

(57) **Abstract**

The invention relates to a semiconductor device for electro-optic applications of the type including at least a rare-earth ions doped P/N junction integrated on a semiconductor substrate. This device may be used to obtain laser action in Silicon and comprises a cavity or a waveguide and a coherent light source obtained incorporating the rare-earth ions, and specifically Erbium ions, in the depletion layer of said P/N junction.

The junction may be for instance the base-collector region of a bipolar transistor and is reverse biased.

## Description

### Background of the invention

The present invention relates in its more general aspect to a semiconductor device for electro-optic applications.

The invention relates also to a method for manufacturing said semiconductor device and to a corresponding semiconductor laser device.

More specifically, the invention relates to a semiconductor device including at least a rare-earth ions doped P/N junction integrated on a semiconductor substrate.

### Prior Art

As it is well known in this specific technical field, Silicon semiconductor is the material most commonly used for manufacturing advanced microelectronic devices in electronic technology.

The electronic technology may be considered nowadays mature and a new optical communication technology is emerging.

For this kind of optical technology the basic information is carried by optical signals having standard wavelengths comprised in the range between 1.3 and 1.55 microns.

It would be highly desirable to combine optical and electronic functions in silicon to implement opto-electronic applications in a single semiconductor device. A significant progress has recently been made in the combination of electronic and optical technologies for manufacturing semiconductor optical devices operating at near infrared wavelengths.

Few examples are the following :
optical waveguides can be made with low losses, as disclosed by U. Fisher, T. Zinke, J.-R. Kropp, F. Arndt and K. Petermann, in the IEEE article: "Photonics Technology Letters" 8 647 (1996);
light emitting diodes based on Erbium (Er) doping have been demonstrated, as reported by S. Coffa, G. Franzò and F. Priolo, in the MRS Bulletin on "Si-based optoelectronics" 23 n. 4, edited by Materials Research Society, S. Coffa and L. Tsybeskov guest editors;
optical switches based on an electro-optic effect can be realized on Silicon, as disclosed by A. Cutolo, M. Iodice, P. Spirito and L. Zeni, J. of lightwave Technology 15, 505 (1997)

There is however a main limitation for using Silicon in optical applications such as, for example, optical interconnections intra-chip or between chips. This main limitation is due to the lack of a coherent light source, i.e. a Silicon-based laser. Silicon is unsuitable to an efficient light emission due to its indirect band gap.

Several approaches are nowadays used to try to overcome this problem. The use of optical doping of Silicon with rare earth ions, with or without impurities such as O, F, N, presents several interesting features not only for manufacturing efficient light emitting diodes, but also for the attempt of realising a Silicon-based lasers.

Indeed, efficient room temperature electro-luminescence from Erbium-Oxygen co-doped Silicon diodes has been reported. Moreover, the long spontaneous lifetime of the first excited state of erbium (about 1 ms), can certainly guarantee the achievement of a population inversion which is needed for an efficient light emission.

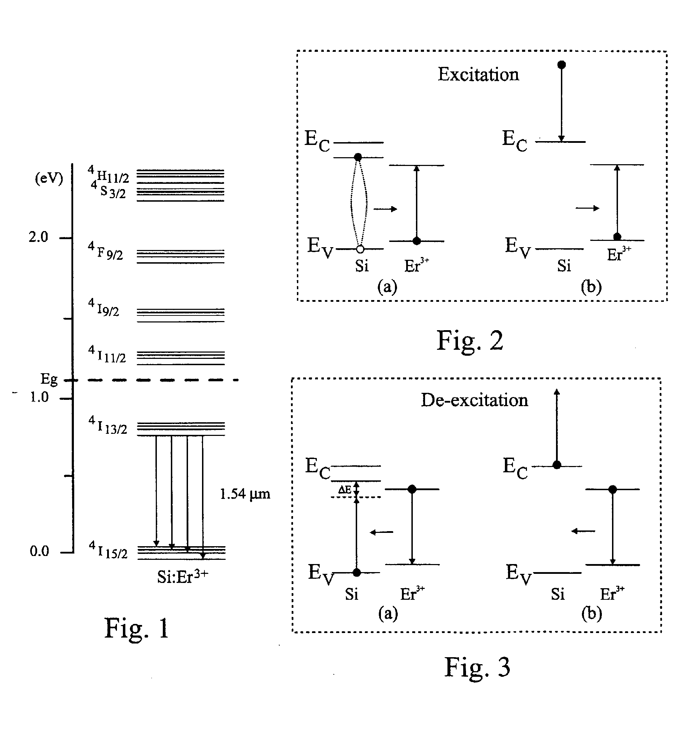

To fully understand all the aspects of the present invention, a schematic diagram of the mechanisms connected to electrical pumping of Erbium ions is shown in Figures 1, 2a, 2b, 3a and 3b.

A room temperature electro-luminescence at 1.54 µm wavelenght can be achieved when Er ions are incorporated into a p-n diode junction.

A known solution is discloded for instance in the US patent No. 5,107,538 that relates to an optical waveguide system comprising a rare-earth Si-based optical device.

This device, however, produces a luminescence only at a temperature close to 4 K and the efficience of the light emission is extremely reduced at room temperature. Moreover, no teachings may be traced in this documents about the rere-earth ions location inside the junction.

Therefore, the light emission obtained by this technology is insufficient for implementing commercial devices and no electro-optical products on Silicon are known on the market.

The object of the present invention is to provide a new semiconductor device having structural and functional features to allow the implementation of a coherent light emitting source into a semiconductor substrate including a rare-earth ions doped junction.

A further object of the present invention is to provide means for allowing optical interconnections intra-chip or between chips.

A further object of the invention is to provide a single chip integrated semiconductor laser device.

Another object of the present invention is to provide a new semiconductor device having structural and functional features to allow the implementation of a coherent light emitting source in Silicon.

A further object of the invention is to provide a single chip integrated Silicon laser device.

Moreover, the aim of the invention is that of providing an electrically pumped optical amplification and laser action at room temperature.

### Summary of the invention

The solution idea on which the invention is based is that of obtaining an electrically pumped optical amplification, and laser action using Erbium-doped crystalline Silicon. The semiconductor device according to the invention comprises an Erbium-doped p-n junction integrated within a semiconductor cavity or waveguide.

The invention allows to combine impact excitation of Er ions by hot carriers in the depletion layer of the reverse biased junction with a proper Er doping and electric field distribution.

Electro-optical amplification is provided by the embodiment of all the Er ions within the depletion layer of the semiconductor device providing also proper acceleration of the carriers before they enter the Er-doped region.

According to this solution idea the invention relates to a semiconductor device defined by the enclosed claim 1.

The invention relates also to a semiconductor laser device according to claim 11.

Moreover, the invention relates to a method for manufacturing a semiconductor device as defined in claim 21.

The features and the advantages of the semiconductor device and corresponding manufacturing method according to the invention, will become clear from the following description of a preferred embodiment given as non-limiting example with reference to the attached drawings.

### Brief description of the drawings

Figure 1 shows a schematic diagram of 4f electronic levels of an Erbium ion and the transitions giving rise to a 1.54 µm light emission;
Figures 2a and 2b show the excitation mechanism for rare earth ions in crystalline Silicon, the specific case of Er ions is illustrated;
Figures 3a and 3b show the de-excitation mechanisms for rare earth ions in crystalline Silicon;
Figures from 4 to 8 are schematic cross sectional views of the semiconductor device according to the invention during the subsequent steps of its manufacturing process;
Figure 9 shows a cross-sectional perspective view of a semiconductor device according to the present invention;
Figure 10 shows a schematic view of a vertical cross-section of the semiconductor device of Figure 9 evidencing the location of the rare earth ions needed to achieve laser action according to the present invention;
Figure 11 shows a schematic view of a dark region in the central depletion layer where Er ions are pumped by impact excitation according to the prior art;
Figure 12 shows a diagram of the doping concentration versus doping depth for the semiconductor device of the present invention;
Figure 13 shows a diagram of the electric field versus doping depth for the semiconductor device of the present invention.

### Detailed description

With reference to the enclosed drawing, with 1 is globally and schematically shown a semiconductor device realised according to the present invention for electro-optic applications. The semiconductor material of the present invention is Silicon.

The process for manufacturing the semiconductor device 1 will now be disclosed. The specific features of the inventive semiconductor device 1 will be discussed later for description convenience.

The manufacturing process is described hereinafter step by step.

A SOI (Silicon-On-Insulator) wafer is provided to be used as a substrate 2 for the semiconductor device 1 according to the invention.

A known SIMOX or BESOI technology may be used to provide said SOI wafer.

However, instead of using a SOI wafer, the substrate for the semiconductor device 1 may simply comprise a double layer of a semiconductor material, for instance a first highly doped substrate layer and a second upper lightly doped epitaxial layer. In such a case the lower substrate layer would have a lower refraction index and would act as a reflective layer for the incident light.

The SOI substrate 2 is formed by a first lower monocrystalline layer 3, an oxide layer 4, and a second upper monocrystalline layer 5. The first and the second monocrystalline layers may be doped with a dopant having a first conductivity type, for instance N-type.

The second upper layer 5 is less doped than the first lower layer 3.

An oxide layer 7 is grown on top of the substrate 2, that is over the second upper monocrystalline layer 5.

A photolitographic process step is then provided to define an aperture 8 in said oxide layer 7 and to selectively realise a doped region 10. The dopant used for this region 10 has an opposite conductivity type, for instance P-type.

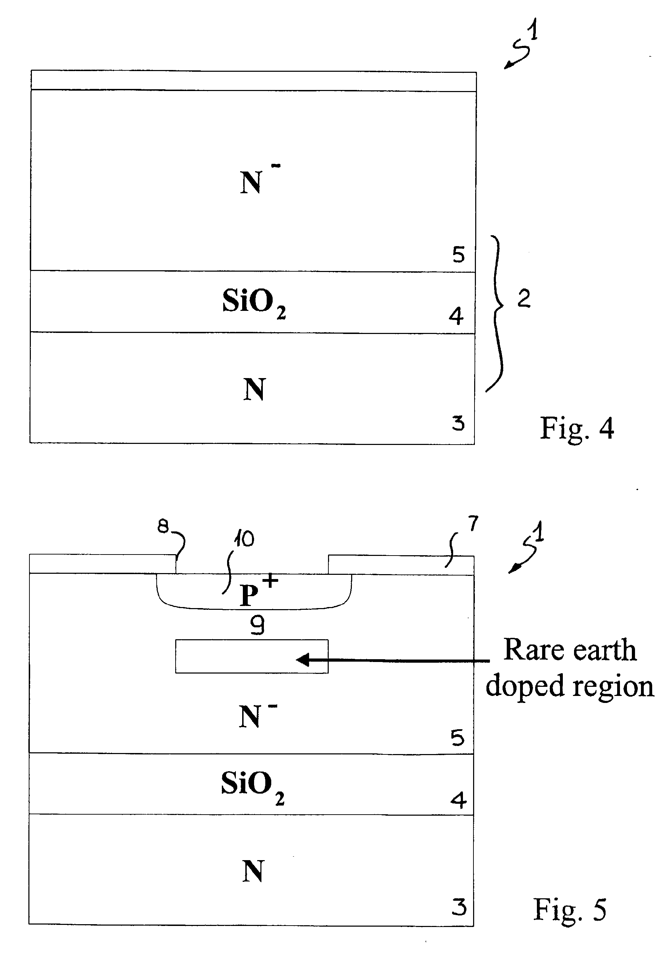

A masked implantation step of B ions in the upper layer 5 allows to realise this p+ doped region 10, as shown in Figure 5.

Through the same mask a rare-earth ions doped region 9 is formed. For example, a ion implantation process step is performed to obtain a region 9 under said p+ doped region 10, as shown in Figure 5. Preferably, said rare earth ions are selected from the group comprising Erbium (Er). A proper co-doping with other impurities, such as O, F, N, may also be used.

Rare earths (RE) incorporation can be achieved using different techniques, such as ion implantation, Molecular Beam Epitaxy (MBE), Chemical Vapor Deposition (CVD), ion assisted deposition, Si-epitaxial regrowth on shallow RE-doped regions. Obviously, different techniques may require different process steps.

The region 9 is an N-type doped region and the stack formed by the regions 5, 9 and 10 form substantially a PN diode junction.

A skilled man may appreciate that the semiconductor device structure of the present invention is similar to a base-collector junction of a bipolar transistor.

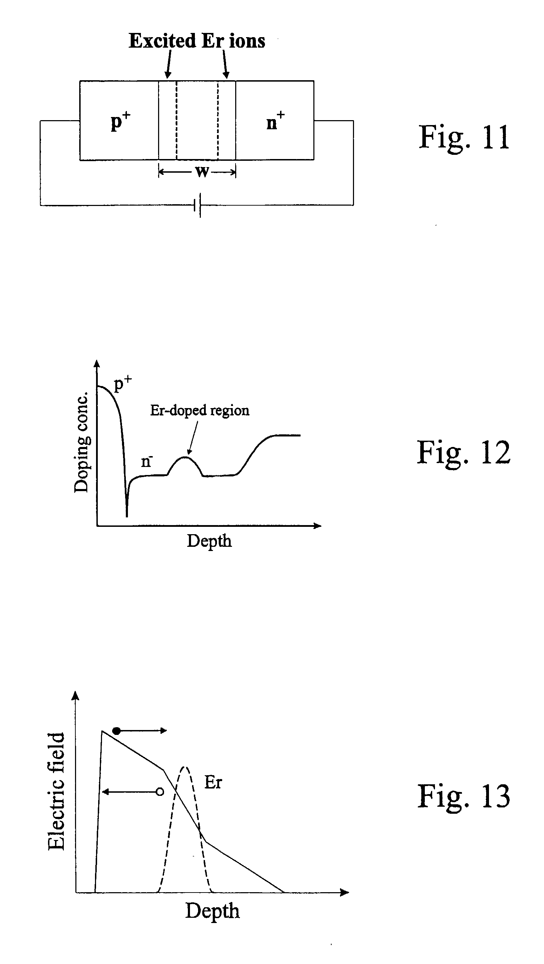

Advantageously, according to the invention, all the implanted Er ions are incorporated in the depletion layer of the PN junction formed by the regions 5, 9 and 10, as clearly shown in Figure 13. Alternatively, all the implanted Er ions are incorporated in the depletion layer of the base collector region of said bipolar transistor.

A masked etching process step is then performed to protect the stacked regions 5, 9 and 10 and to etch the semiconductor at both sides of those regions 9 and 10 to provide a projecting stack region 6 formed just by the p+ doped region 10 and part of the region 5.

A dry or wet etching step may be used for etching the semiconductor.

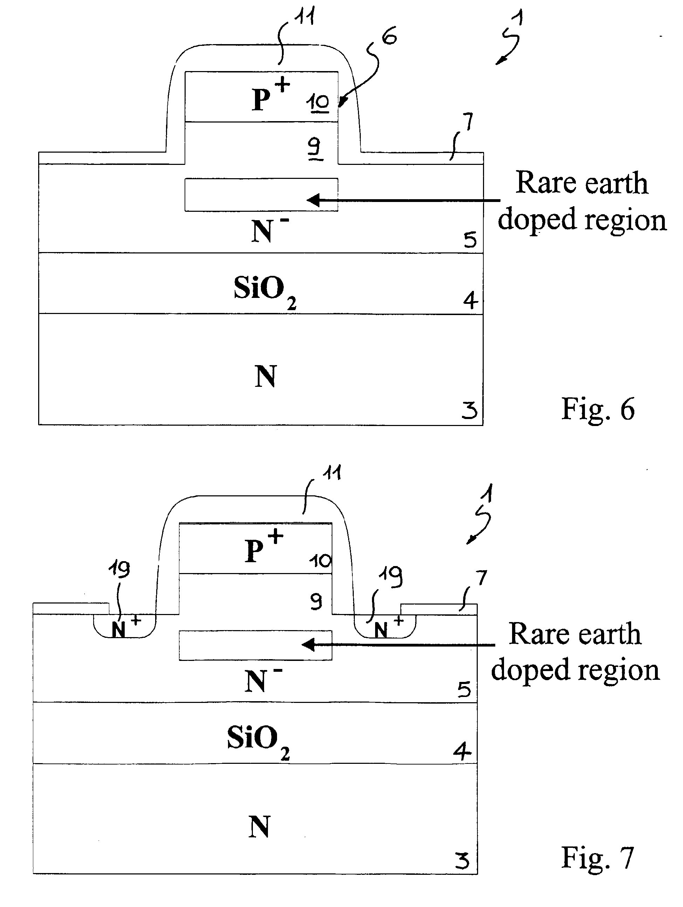

A protective oxide layer 11 is deposited over the resulting stack, as shown in Figure 6.

This protective oxide layer 11 allows to envelope the stack 6 formed by the regions 9 and 10 by a material having a lower dielectric constant.

As a result, a laser cavity or waveguide is obtained on Silicon with the oxide layer 11 delimiting the sides of the waveguide and the buried oxide layer delimiting the bottom of the waveguide.

The device obtained with the inventive method allows to confine light in a two dimensional plane perpendicular to the direction of propagation of the electromagnetic wave. Hence, the semiconductor region containing the gain medium, that is the Erbium ions concentration, is surrounded by a cavity structure or waveguide delimited by a material having a lower refractive index.

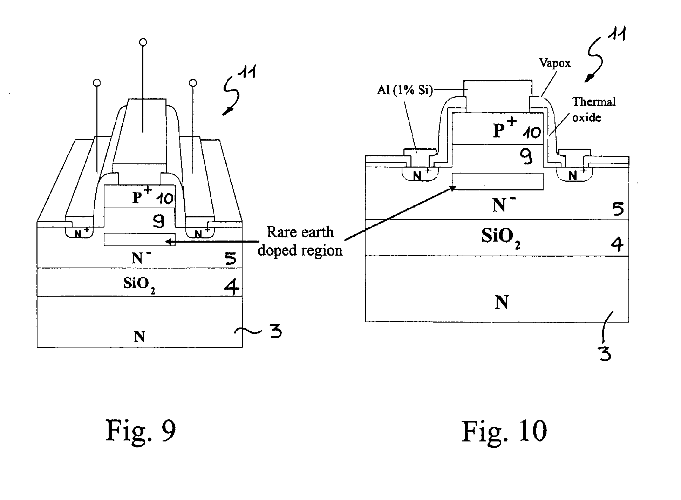

We have disclosed an example to obtain a weveguide having substantially a rib elongated structure as shown in Figure 9. However, other examples may be proposed such as planar waveguides in which the lateral confinement is obtained for instance by shallow trenches filled by a lower refractive index material, or by heavily doped regions as one of the many possible alternatives.

The manufacturing process is carried on by a further masked implantation step of n-type dopants.

Using a suitable mask, not shown, a portion of the protective oxide layer 11 is removed over the upper substrate layer 5, close to the stack 6. N-type dopants, for instance P ions, are implanted in the upper layer 5 thereby forming contact n+ regions 19, as shown in Figure 7.

A further oxide layer is deposited over the whole semiconductor portion and a masked process is used to define contacts openings over the p+ region 10 and over the n+ regions 19.

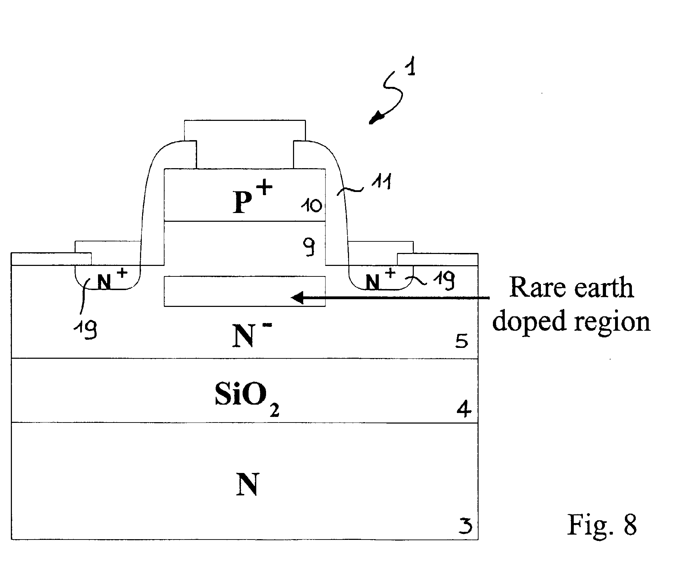

A final deposition step of a metal layer, followed by a lithography step, is performed to define the metal contacts on the p+ and n+ regions 10 and 19 as shown in Figure 8.

The resulting structure is clearly shown in Figure 9 which is a schematic vertical cross-section and perspective view of the semiconductor device 1 including a cavity or waveguide and a p-n diode junction.

Let's now evaluate the specific features of the semiconductor device structure 1 obtained according to the process previously disclosed.

Er ions can be effectively pumped by electron-hole (e-h) recombination, under forward bias diode operation, at temperature below 200 K. However, a phenomenon know as Auger de-excitation and back energy transfer strongly reduces the efficiency of light emission at higher temperatures.

According to the invention, these negative effects are fully inhibited under reverse bias conditions thereby allowing to achieve strong light emission at room temperature.

In fact, all of the implanted Er ions are incorporated in the depletion layer of a p-n junction or, alternatively, in the depletion layer of the base collector region of the bipolar transistor.

Since the characteristic of the invention is the incorporation of the rare earth ions in a depletion layer, electrical pumping of these ions can be achieved in different device structures such as: Schottky diodes, bipolar transistors; MOSFET devices, etc.

Moreover, a sufficient acceleration space is provided before carriers either generated by tunneling in a reverse biased p-n junction or injected by the emitter-base junction of a transistor, enter the Er-doped regions: following this approach population inversion will be extended to all of the Er ions.

After having achieved laser operation at room temperature, an efficient electronic pumping effect can be maintained at room temperature according to the present invention.

Therefore, according to the invention, a proper semiconductor laser device may be realised incorporating the rare-earth ions in a laser cavity which presents low losses at the emission wavelength.

In this respect, the use of a Silicon substrate is certainly an advantage since Silicon semiconductor is almost transparent at the 1.54 µm wavelength. Indeed, integrated Silicon waveguides using Silicon as the core material and Silicon Oxide (SiO2) as claddings have already been manufactured and present losses as low as 0.1 dB/cm.

According to the invention, rare-earth ions doping of these waveguides, within an integrated devices structure allowing electrical pumping of the rare earth ions, can be used to produce the laser cavity.

Diode operation at the diode breakdown threshold results in an intense light emission at 1.54 µm, characterised by an internal quantum efficiency of about 0.1 %.

It may be demonstrated that in such a structure the Er ions are pumped to the excited levels as a result of impact excitation by hot carriers.

Impact excitation with hot carriers is provided to invert Er population rather than electron-hole recombination.

During pumping, since the Er ions are embodied in the depletion layer of a junction, the losses due to the free electrons will be fully inhibited and the laser action would benefit of the extremely low losses that intrinsic Silicon exhibit at 1.54 µm.

This amplification gain at 1.54 µm can overcome waveguide losses and laser action can be achieved if a proper cavity reflectors structure can be realised, as the inventive method has demonstrated.

In order to remark how to obtain a proper laser action reference is still made to the schematic view of Figure 9. The semiconductor device 1 is realised using a silicon on insulators (SOI) substrate 2 and the process previously disclosed. The stacked p-n junction 6 is doped with rare earth ions. Er pumping will result in light emission coupled to the fundamental modes of the cavity. This structure could be used both as an electrically pumped optical amplifier or as a laser, if proper feedback can be achieved. Cleaved output and input waveguide facets, or distributed Bragg reflector structures, can be suitably used to provide the feedback needed for laser action.

The most important limitation that the invention has overcome was due to an insufficient Er concentration in order to achieve a laser action at 1.54 µm in the Er-doped Silicon substrate using an integrated waveguide.

Since Erbium in Silicon acts as a donor, a high concentration of free electrons in the region where Erbium sits is present. It should be noted that, in order to incorporate high Er concentration in Silicon semiconductor, co-doping with impurities such as O and F plays a fundamental role. However this co-doping also produces a strong donor activity of the Er ions resulting in a high concentration of free electrons in the region where Er sits.

When Erbium is incorporated within a structure, such as the channel waveguide previously disclosed, the strong concentration of free electrons will produce, by the plasma dispersion effect, strong losses which would make impossible the achievement of a net gain. Indeed, free carrier concentration has to be maintained below 10¹⁷/cm³ to achieve low losses.

In fact, due to the donor behavior of Er, both the real and the imaginary part of the refractive index are strongly affected by the high free carrier concentration, and the mode tends to escape from the region where Er sits. Moreover, effective loss as high as ∼ 200 cm⁻¹ can be obtained.

A problem to be solved results from the use of impact excitation of Er ions in reverse biased p-n junctions because of the existence of a "dark region" in the central portion of the depletion layer where carriers have not enough energy to pump Er ions.

It has been experimentally demonstrated by S. Coffa, G. Franzò, F. Priolo, A. Pacelli, A. Lacaita, Appl. Phys. Lett. 73, 93 (1998) that a region of about 400 Å in the central portion of about 1000 Å thick depletion layer, is dark.

Such a behavior is schematically shown in Figure 11. In fact, the peculiar feature of impact excitation is due to the existence of a threshold. If the energy of the carrier is lower than that required to promote the Er ions to the first excited state (0.8 eV) the process cannot occur.

A second problem is that the Er ions sitting outside the depletion layer cannot be pumped by this mechanisms, hence will not be excited, but will adsorb light at 1.54 µm.

The Er population cannot hence be inverted in the central part of the diode since there the energy of the carriers, produced by band to band tunneling and then accelerated by the strong electric field present at the junction, is not sufficient to pump Er.

An effective pumping of Er ions in order to achieve population inversion and the capability of maintaining low losses in the Er doped waveguides is achieved by the inventive structure. How the invention solves these two problems is examined in details hereinafter.

The inventive device and method solve all the previously remarked problems by incorporating all the implanted Er ions in the depletion layer of the p-n junction and providing:
1. a sufficient acceleration space before carriers enter the Er-doped regions.
2. population inversion extended to all the Er ions.
3. Inhibition of loss due to free electrons just because the Erbium ions are embodied in the junction depletion layer. The laser action would benefit of the extremely low loss that intrinsic Si exhibits at 1.54 µm. Er has been placed where the maximum of the mode sits.

Since the Erbium ions sit in the depletion region, the free carrier concentration strongly decreases and effective loss as low as 0.6 cm⁻¹ has been evaluated.

## Claims

1. Semiconductor device for electro-optic applications of the type including at least a rare-earth ions doped P/N junction integrated on a semiconductor substrate, a cavity or a waveguide and a coherent light source, characterised in that said coherent light source is obtained incorporating said rare-earth ions in the depletion layer of said P/N junction.

2. Semiconductor device according to claim 1, wherein said P/N junction is reverse biased.

3. Semiconductor device according to claim 1, wherein said rare-earth ions doped P/N junction is the base-collector region of a bipolar transistor.

4. Semiconductor device according to claim 1, wherein said rare-earth ions are Erbium ions.

5. Semiconductor device according to claim 1, wherein said cavity or waveguide includes said P/N junction and is partially enveloped by a protective layer having a lower dielectric constant with respect to said junction.

6. Semiconductor device according to claim 1, wherein a buried reflecting layer is provided to delimit the bottom of said waveguide.

7. Semiconductor device according to claim 1, wherein said semiconductor substrate is a SOI substrate.

8. Semiconductor device according to claim 1, wherein said semiconductor substrate is an epitaxial layer covering an heavily doped substrate layer.

9. Semiconductor device according to claim 1, wherein said cavity or waveguide has a rib elongated structure projecting from the semiconductor surface.

10. Semiconductor device according to claim 1, wherein said semiconductor is Silicon.

11. Semiconductor laser device comprising at least a rare-earth ions doped P/N junction integrated on a semiconductor substrate, a cavity or waveguide and a coherent light emitting source, characterised in that said device comprises includes a biasing device and incorporates said rare-earth ions in the depletion layer of said P/N junction.

12. Semiconductor laser device according to claim 10, wherein said biasing device is a bipolar transistor and said P/N junction is the base-collector region of said bipolar transistor.

13. Semiconductor laser device according to claim 10, wherein said P/N junction is reverse biased.

14. Semiconductor laser device according to claim 10, wherein said rare-earth ions are Erbium ions.

15. Semiconductor laser device according to claim 10, wherein said cavity or waveguide includes said P/N junction and is partially enveloped by a protective layer having a lower dielectric constant with respect to said junction.

16. Semiconductor laser device according to claim 10, wherein said cavity or waveguide has a rib elongated structure projecting from the semiconductor surface.

17. Semiconductor laser device according to claim 10, wherein said semiconductor substrate is a SOI substrate.

18. Semiconductor laser device according to claim 10, wherein said semiconductor substrate is an epitaxial layer covering an heavily doped substrate layer.

19. Semiconductor laser device according to claim 10, wherein a buried reflecting layer is provided to delimit the bottom of said waveguide.

20. Semiconductor laser device according to claim 10, wherein said semiconductor is Silicon.

21. A method for manufacturing a semiconductor device for electro-optic applications, said device including at least a rare-earth ions doped P/N junction integrated on a semiconductor substrate, characterised in that of providing a cavity or waveguide in said semiconductor substrate and a coherent light emitting source incorporating said rare-earth ions in the depletion layer of said P/N junction.

22. Method according to claim 21, wherein a biasing device is also provided to bias said P/N junction.

23. Method according to claim 21, wherein said biasing device is a bipolar transistor and said rare-earth ions doped P/N junction forms the base-collector region of said bipolar transistor.

24. Method according to claim 21, wherein said rare-earth ions are Erbium ions.

25. A method for manufacturing a semiconductor laser device for electro-optic applications, said device including at least a rare-earth ions doped P/N junction integrated on a semiconductor substrate, characterised in that of providing a cavity or waveguide in said semiconductor substrate and a coherent light emitting source comprising a biasing device and a concentration of said rare-earth ions in the depletion layer of said P/N junction.

26. Method according to claim 25, wherein said biasing device is a bipolare transistor and said rare-earth ions doped P/N junction forms the base-collector region of said bipolar transistor.

27. Method according to claim 25, wherein said rare-earth ions are Erbium ions.
